# EUROPEAN PATENT APPLICATION

(11) **EP 4 694 178 A2**
(43) Date of publication of application: **11.02.2026**
(21) Application number: 25194640.6
(22) Date of filing: 07.08.2025
(51) Int. Cl.: H04Q 1/02, H05K 7/14

(54) **TELECOMMUNICATIONS RACK MOVER AND TRANSPORT SYSTEM**

(30) Priority: 09.08.2024 US 202463681440 P
(71) Applicant: Corning Research & Development Corporation, Corning, New York 14831 (US)
(72) Inventor: GIRAUD, William Julius McPhil, Azle, 76020 (US); STEPHENS, Whitney, Kennendale, 76060 (US)
(74) Representative: Reddie & Grose LLP

(57) **Abstract**

**In** general, the present disclosure relates to a telecommunications rack mover that enables safe lifting and transport of telecommunications racks. The telecommunications rack mover is movable such that the telecommunications rack mover can be positioned within the telecommunications rack. **In** particular, the telecommunications rack mover is expandable such that the telecommunications rack mover engages with and lifts the telecommunications rack off the floor. **In** this configuration, the telecommunications rack is movable while in engagement with the telecommunications rack mover. Once moved to the desired location, the telecommunications rack mover lowers the telecommunications rack and disengages with the telecommunications rack. Then, the telecommunications rack mover is compressed and removed from below the telecommunications rack.

## Description

### PRIORITY APPLICATION

This application claims the benefit of priority of U.S. Provisional Application No. 63/681,440, filed on August 9, 2024, the content of which is relied upon and incorporated herein by reference in its entirety.

### FIELD

This disclosure generally pertains to telecommunications racks, and more particularly, to a system and method for lifting and transporting a telecommunications rack.

### BACKGROUND

Telecommunications equipment, such as fiber optic equipment racks or telecommunications racks may include a frame configured to house servers, networking devices, cables, other fiber optic equipment, or the like. Typical telecommunications racks are installed in rows within an environment (e.g., data centers or central offices) and can be physically bolted to the floor and to each other. These telecommunications racks are typically installed empty, i.e., without other fiber optic equipment (e.g., servers, networking devices, cables, etc.) housed in the telecommunications rack.

The empty telecommunications racks can be movable within their environment (e.g., data centers or central offices) due to their light weight. However, as telecommunications racks have fiber optic equipment pre-loaded within the telecommunications racks, transportation becomes challenging due to the increased weight - telecommunications racks may weigh several hundred pounds and be difficult to maneuver in a datacenter, or other facility. Also, in some cases, customers may request fully or partially populated telecommunications racks, e.g. at least a portion of the telecommunications rack cabinet is populated with fiber optic equipment, which also adds a considerable weight to the telecommunications rack during the installation process.

As such, there is a need to be able to safely and effectively move telecommunications racks that can have fiber optic equipment loaded therein.

### SUMMARY

In general, the present disclosure relates to a telecommunications rack mover that enables safe lifting and transport of telecommunications racks. The telecommunications rack mover is movable such that the telecommunications rack mover can be positioned within the telecommunications rack. In particular, the telecommunications rack mover is expandable such that the telecommunications rack mover engages with and lifts the telecommunications rack off the floor. In this configuration, the telecommunications rack is movable while in engagement with the telecommunications rack mover. Once moved to the desired location, the telecommunications rack mover lowers the telecommunications rack and disengages with the telecommunications rack. Then, the telecommunications rack mover is compressed and removed from below the telecommunications rack.

In one embodiment, an expandable frame for moving a telecommunications rack is provided. The expandable frame comprising: a first main bar and a second main bar, the second main bar being substantially parallel with the first main bar; a first cross bar coupled to the first main bar and the second main bar; and a second cross bar coupled to the first main bar and the second main bar, the second cross bar being substantially parallel with the first cross bar; wherein the expandable frame is movable between a compressed configuration and an expanded configuration; wherein in the compressed configuration, the first main bar and the second main bar are adjacent to each other; and wherein in the expanded configuration, the first main bar is spaced apart from the second main bar.

In another embodiment, the first cross bar is coupled to the first main bar and the second main bar at a first pivot point and a second pivot point, respectively; the second cross bar is coupled to the first main bar and the second main bar at a third pivot point and a fourth pivot point, respectively; and when the expandable frame transitions between the compressed configuration and the expanded configuration, the first cross bar pivots about the first pivot point and the second point and the second cross bar pivots about the third pivot point and the fourth pivot point. In another embodiment, the first pivot point, the second pivot point, the third pivot point, and the fourth pivot point each comprise a lifting bolt that engages with the corresponding first main bar, the second main bar, the first cross bar, and the second cross bar. In another embodiment, when the lifting bolt is tightened, the first cross bar or the second cross bar is moved from a first position relative to the first main bar or the second main bar to a second position relative to the first main bar or the second main bar, wherein the second position is closer to the first main bar or the second main bar than the first position. In another embodiment, the first cross bar and the second cross bar are each configured to engage with a telecommunications rack when the expandable frame is in the expanded configuration and when the first cross bar and the second cross bar are in the second position. In another embodiment, the expandable frame is configured to lift the telecommunications rack from a resting position to a movable position when the first cross bar and the second cross bar engage with the telecommunications rack in the second position. In another embodiment, when the lifting bolt is loosened the first cross bar or the second cross bar is moved to the first position, and the telecommunications rack is moved to the resting position. In another embodiment, the first main bar and the second main bar each include at least one caster configure to enable movement of the expandable frame.

In one embodiment, an expandable frame is provided. The expandable frame comprising: a first main bar having a first end and a second end; a second main bar having a first end and a second end, the second main bar being substantially parallel with the first main bar; a first cross bar coupled to the first main bar and the second main bar; a second cross bar coupled to the first main bar and the second main bar, the second cross bar being substantially parallel with the first cross bar; a first stabilizer bar pivotably coupled to the first end of the first main bar; a second stabilizer bar pivotably coupled to the second end of the first main bar; a third stabilizer bar pivotably coupled to the first end of the second main bar; a fourth stabilizer bar pivotably coupled to the second end of the second main bar; wherein the expandable frame is movable between a compressed configuration and an expanded configuration; wherein in the compressed configuration, the first main bar and the second main bar are adjacent to each other; wherein in the expanded configuration: the first main bar is spaced apart from the second main bar; the first stabilizer bar and the second stabilizer bar are pivotable between a stored configuration in which the first stabilizer bar and the second stabilizer bar are substantially parallel to the first cross bar and the second cross bar and an assembled configuration in which the first stabilizer bar and the second stabilizer bar are substantially perpendicular to the first main bar and the second main bar; and the third stabilizer bar and the fourth stabilizer bar are pivotable between a stored configuration in which the third stabilizer and the fourth stabilizer bar are substantially parallel to the first cross bar and the second cross bar and an assembled configuration in which the third stabilizer bar and the fourth stabilizer bar are substantially perpendicular to the first main bar and the second main bar.

In another embodiment, in the expanded configuration: the first stabilizer bar and the third stabilizer bar are coupled to each other; and the second stabilizer bar and the fourth stabilizer bar are coupled to each other. In another embodiment, the expandable frame further comprising at least one handle coupled to at least one of the first stabilizer bar and the third stabilizer bar in the assembled configuration or at least one of the second stabilizer bar and the fourth stabilizer bar in the assembled configuration. In another embodiment, the first cross bar is coupled to the first main bar and the second main bar at a first pivot point and a second pivot point, respectively; the second cross bar is coupled to the first main bar and the second main bar at a third pivot point and a fourth pivot point, respectively; when the expandable frame transitions between the compressed configuration and the expanded configuration, the first cross bar pivots about the first pivot point and the second point and the second cross bar pivots about the third pivot point and the fourth pivot point. In another embodiment, the first pivot point, the second pivot point, the third pivot point, and the fourth pivot point each comprise a lifting bolt that engages with the corresponding first main bar, the second main bar, the first cross bar, or the second cross bar. In another embodiment, the expandable frame further comprising: a jack assembly coupled to the expandable frame in the expanded configuration, wherein the jack assembly comprises a jack that is coupled to the expandable frame such that the jack raises or lower the lifting bolt to transition the lifting bolt between a first position relative to the first main bar or the second main bar and a second position relative to the first main bar or the second main bar; wherein the second position of the lifting bolt is closer to the first main bar or the second main bar than the first position of the lifting bolt.

In one embodiment, a method of moving a telecommunications rack using an expandable frame that includes a first main bar, a second main bar that is substantially parallel with the first main bar, a first cross bar coupled to the first main bar and the second main bar, and a second cross bar coupled to the first main bar and the second main bar, wherein the second cross bar is substantially parallel with the first cross bar is provided. The method comprising: moving the expandable frame into a base of the telecommunications rack when the expandable frame is in a compressed configuration in which the first main bar and the second main bar are adjacent to each other; expanding the expandable frame from the compressed configuration to an expanded configuration in which the first main bar is spaced apart from the second main bar; engaging the first cross bar and the second cross bar with the telecommunications rack; lifting the telecommunications rack using the expandable frame; and moving the telecommunications rack using the expandable frame.

In another embodiment, the first cross bar is coupled to the first main bar and the second main bar at a first pivot point and a second pivot point, respectively; the second cross bar is coupled to the first main bar and the second main bar at a third pivot point and a fourth pivot point, respectively; when the expandable frame transitions between the compressed configuration and the expanded configuration, the first cross bar pivots about the first pivot point and the second point and the second cross bar pivots about the third pivot point and the fourth pivot point. In another embodiment, engaging the first cross bar step comprises actuating a lifting bolt that engages with the first main bar, the second main bar, the first cross bar, or the second cross bar; wherein when the lifting bolt is tightened, the first cross bar or the second cross bar is moved from a first position relative to the first main bar or the second main bar to a second position relative to the first main bar or the second main bar, wherein the second position is closer to the first main bar or the second main bar than the first position. In another embodiment, the method further comprising: pivoting a first stabilizer bar, a second stabilizer bar, a third stabilizer bar, and a fourth stabilizer bar such that the first stabilizer bar and the second stabilizer bar are coupled to each other when the expandable frame is in the expanded configuration, and the third stabilizer bar and the fourth stabilizer bar are coupled to each other when the expandable frame is in the expanded configuration. In another embodiment, the method further comprising: coupling a jack of a jack assembly to the expandable frame; and actuating the jack to engage the first cross bar and the second cross bar with the telecommunications rack to lift the telecommunications rack.

Additional features and advantages will be set forth in the detailed description which follows, and in part will be apparent to those skilled in the art from the description or recognized by practicing the embodiments as described in the written description and claims hereof, as well as the appended drawings.

It is to be understood that both the foregoing general description and the following detailed description are merely exemplary, and are intended to provide an overview or framework to understand the nature and character of the claims.

The accompanying drawings are included to provide a further understanding, and are incorporated in and constitute a part of this specification. The drawings are illustrative of selected aspects of the present description, and together with the specification explain principles and operation of methods, products, and compositions embraced by the present description. Features shown in the drawing are illustrative of selected embodiments of the present description and are not necessarily depicted in proper scale.

### BRIEF DESCRIPTION OF THE DRAWINGS

While the specification concludes with claims particularly pointing out and distinctly claiming the subject matter of the written description, it is believed that the specification will be better understood from the following written description when taken in conjunction with the accompanying drawings, wherein:
FIG. 1 is a schematic illustration of a data center campus according to an exemplary embodiment of the disclosure;
FIG. 2 is a partial perspective view of an exemplary data hall of the data center shown in FIG. 1;
FIG. 3 is a perspective view of a telecommunications rack that is within the data hall of FIG. 2;
FIG. 4 is a perspective view of a telecommunications rack mover in a compressed configuration in accordance with the present disclosure;
FIG. 5 is a perspective view of the telecommunications rack mover of FIG. 4 in an expanded configuration in accordance with the present disclosure;
FIG. 6 is a cross sectional view of the telecommunications rack mover of FIG. 4 where a cross bar is shown in a second position in accordance with the present disclosure;
FIG. 7 is another cross sectional view of the telecommunications rack mover of FIG. 4 where the cross bar of FIG. 6 is shown in a first position in accordance with the present disclosure;
FIG. 8 is a perspective view of another embodiment of the telecommunications rack mover of FIG. 4 in a compressed configuration in accordance with the present disclosure;
FIG. 9 is a perspective view of the telecommunications rack mover of FIG. 8 in an expanded configuration in accordance with the present disclosure;
FIG. 10 is a perspective view of another embodiment of the telecommunications rack mover of FIG. 4;
FIG. 11 is a perspective view of the telecommunications rack mover of FIG. 10 where handles are added onto the telecommunications rack mover in accordance with the present disclosure;
FIG. 12 is a perspective view of another embodiment of the telecommunications rack mover of FIG. 4; and
FIGS. 13-19 illustrate a method of using the telecommunications rack mover of FIG. 4 in accordance with the present disclosure.

The embodiments set forth in the drawings are illustrative in nature and not intended to be limiting of the scope of the detailed description or claims. Whenever possible, the same reference numeral will be used throughout the drawings to refer to the same or like features. The drawings are not necessarily to scale for ease of illustration an explanation.

### DETAILED DESCRIPTION

Reference will now be made in detail to certain embodiments, examples of which are illustrated in the accompanying drawings, in which some, but not all features are shown. Indeed, embodiments disclosed herein may be embodied in many different forms and should not be construed as limited to the embodiments set forth herein; rather, these embodiments are provided so that this disclosure will satisfy applicable legal requirements. Whenever possible, like reference numbers will be used to refer to like components or parts.

The claims set forth below are incorporated by reference into this Detailed Description section.

Terms like front, back, top, bottom, side, etc. are relative terms used for convenience and ease of explanation and are not intended to be limiting.

Various embodiments will be further clarified by examples in the description below. In general, the present disclosure relates to a telecommunications rack mover that enables safe lifting and transport of telecommunications racks. The telecommunications rack mover is movable such that the telecommunications rack mover can be positioned within the telecommunications rack. In particular, the telecommunications rack mover is expandable such that the telecommunications rack mover engages with and lifts the telecommunications rack off the floor. In this configuration, the telecommunications rack is movable while in engagement with the telecommunications rack mover. Once moved to the desired location, the telecommunications rack mover lowers the telecommunications rack and disengages with the telecommunications rack. Then, the telecommunications rack mover is compressed and removed from below the telecommunications rack.

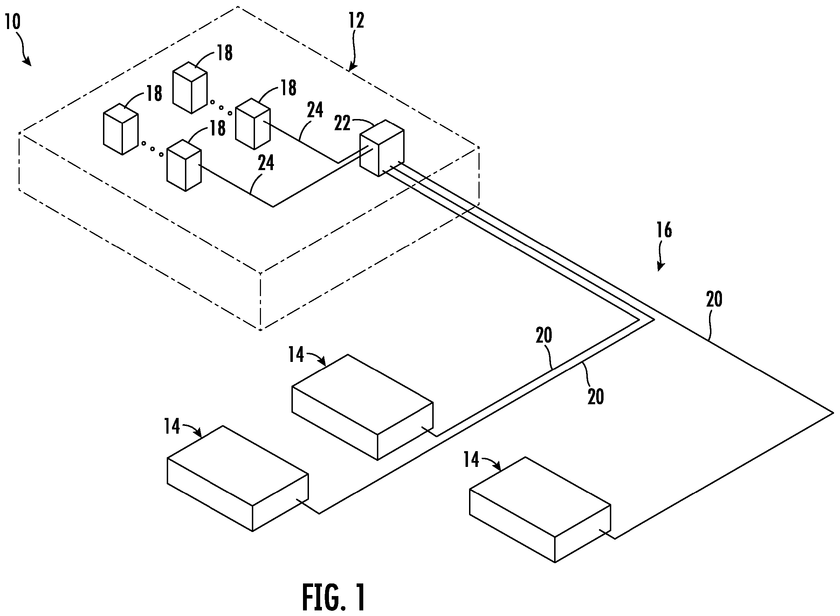

Referring now to the figures, FIG. 1 illustrates a modern-day data center 10 which may include a collection of buildings (referred to as a data center campus) having, for example, a main building 12 and one or more auxiliary buildings 14 in close proximity to the main building 12. While three auxiliary buildings 14 are shown, there may be more or less depending on the size of the campus. The data center 10 provides for a local fiber optic network 16 that interconnects the auxiliary buildings 14 with the main building 12. The local fiber optic network 16 allows network equipment 18 in the main building 12 to communicate with various network equipment (not shown) in the auxiliary buildings 14. In the exemplary embodiment shown, the local fiber optic network 16 includes trunk cables 20 extending between the main building 12 and each of the auxiliary buildings 14. Conventional trunk cables 20 generally include a high fiber-count arrangement of optical fibers for passing data and other information through the local fiber optic network 16. In the example illustrated in FIG. 1, the trunk cables 20 from the auxiliary buildings 14 are routed to one or more distribution cabinets 22 housed in the main building 12 (e.g., one shown).

Within the main building 12, a plurality of indoor fiber optic cables 24 ("indoor cables 24") are routed between the network equipment 18 and the one or more distribution cabinets 22. The indoor cables 24 generally include a high fiber-count arrangement of optical fibers for passing data and other information from the distribution cabinets 22 to the network equipment 18. Although only the interior of the main building 12 is schematically shown in FIG. 1 and discussed above, each of the auxiliary buildings 14 may house similar equipment for similar purposes. Thus, although not shown, each of the trunk cables 20 may be routed to one or more distribution cabinets 22 in one of the auxiliary buildings 14 in a manner similar to that described above. Furthermore, each of the auxiliary buildings 14 may include indoor cables 24 that extend between network equipment 18 and the one or more distribution cabinets 22 of the auxiliary building 14.

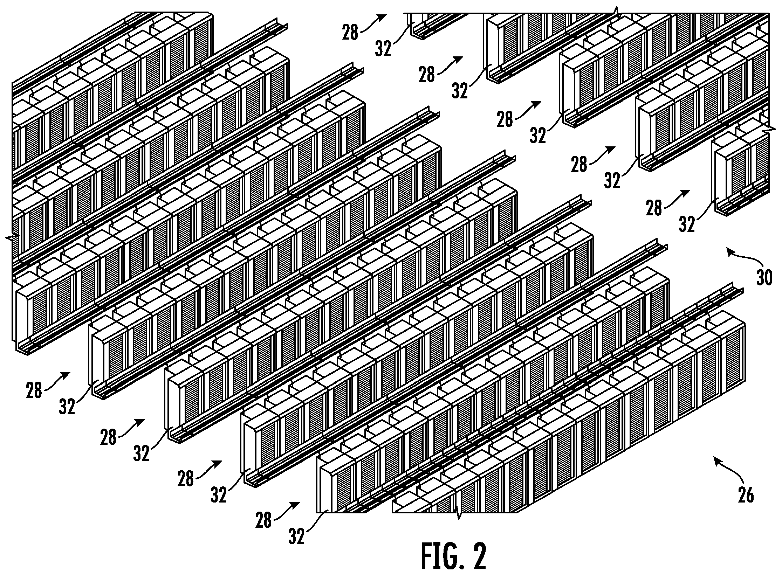

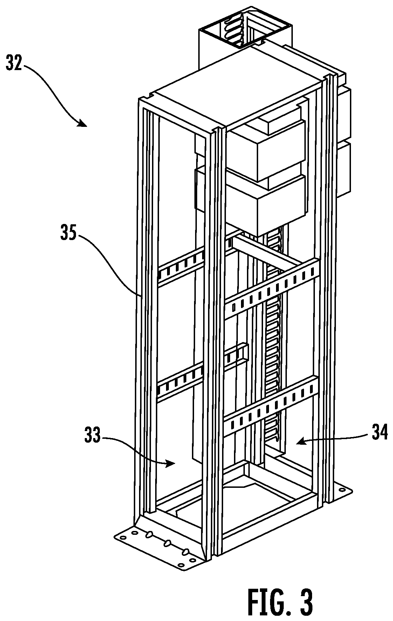

As illustrated in more detail in FIG. 2, the network equipment 18 in the main building 12 (or an auxiliary building 14) may be arranged in one or more data halls 26 that generally include a plurality of spaced-apart rows 28 on one or both sides of an access pathway 30. The arrangement of the data halls 26 into rows 28 helps organize the large number of equipment, fiber optic cables, fiber optic connections, etc. Each of the rows 28 includes a plurality of racks or cabinets 32 (referred to hereafter as "telecommunications racks 32") generally arranged one next to the other along the row 28. Each of the telecommunications racks 32 are vertically arranged frames 35 (FIG. 3) for holding various network equipment 18 of the data center 10, as is generally known in the fiber optics industry.

Referring briefly to FIG. 3, a telecommunications rack 32 is shown in greater detail. As mentioned previously, telecommunications rack 32 is configured to hold various network equipment 18, and the vertically arranged frames 35 of telecommunications rack 32 define a base 34 and a space 33 within the base 34. Base 34 and space 33 are configured to receive a telecommunications rack mover 100 as discussed in greater detail herein.

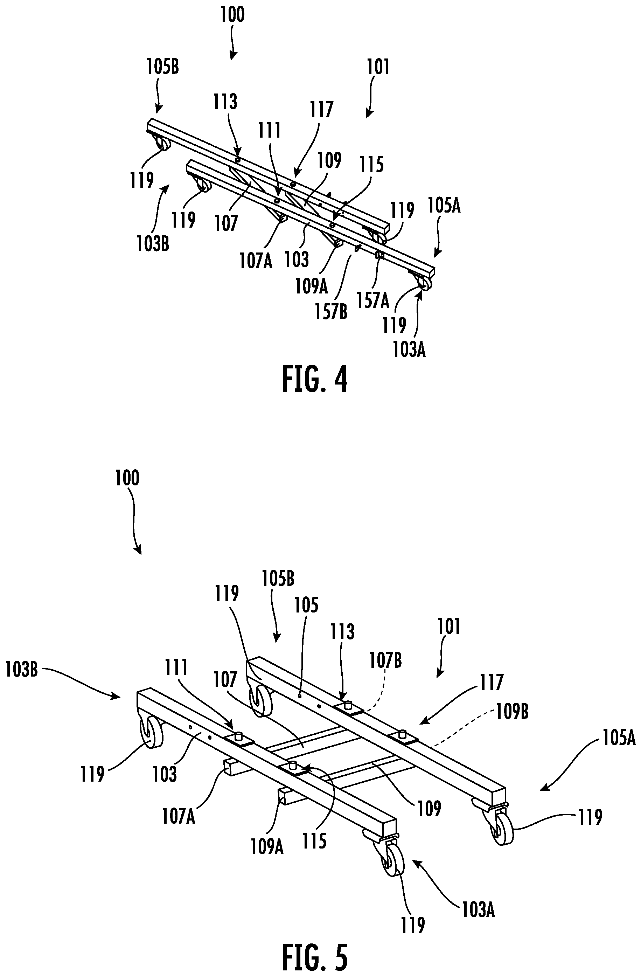

Referring now to FIGS. 4 and 5, telecommunications rack mover 100 is shown in a compressed configuration and expanded configuration, respectively. Telecommunications rack mover 100 comprises an expandable frame 101 that is movable between the compressed and expanded configurations as discussed in greater detail herein. The expanded frame 101 comprises a first main bar 103 and a second main bar 105 that is substantially parallel to the first main bar 103. The first and second main bars 103, 105 are coupled to cross bars 107, 109 of the expandable frame 101 as explained in greater detail herein.

The expandable frame 101 of telecommunications rack mover 100 further comprises a first cross bar 107 and a second cross bar 109 that is substantially parallel to the first cross bar 107. First cross bar 107 and second cross bar 109 each have ends that extend beyond the first main bar 103 and the second main bar 105 to create regions where the first and second cross bars 107, 109 engage with the telecommunications rack 32 to lift and lower the telecommunications rack 32.

As shown, the first cross bar 107 is coupled to the first main bar 103 and the second main bar 105 at a first pivot point 111 and a second pivot point 113. The first pivot point 111 and the second pivot point 113 enable movement of the first cross bar 107 about first and second pivot points 111, 113 to transition expandable frame 101 and telecommunications rack mover 100 between the compressed and expanded configurations. Similar to the first cross bar 107, the second cross bar 109 is coupled to the first main bar 103 and the second main bar 105 at a third pivot point 115 and a fourth pivot point 117. The third pivot point 115 and the fourth pivot point 117 enable movement of the second cross bar 109 about third and fourth pivot points 115, 117 to transition expandable frame 101 and telecommunications rack mover 100 between the compressed and expanded configurations. As shown in FIGS. 4 and 5, in both the compressed and expanded configurations, the first main bar 103 is substantially parallel with the second main bar 105, and the first cross bar 107 is substantially parallel with the second cross bar 109. Also, as shown in FIGS. 4 and 5, in the compressed configuration, the first main bar 103 and the second main bar 105 are substantially adjacent to each other, and the first cross bar 107 and the second cross bar 109 are substantially adjacent to each other. In the expanded configuration, the first main bar 103 is spaced apart from the second main bar 105, and the first cross bar 107 is spaced apart from the second cross bar 109. Additionally, the first cross bar 107 and the second cross bar 109 are substantially perpendicular to the first main bar 103 and the second main bar 105, respectively.

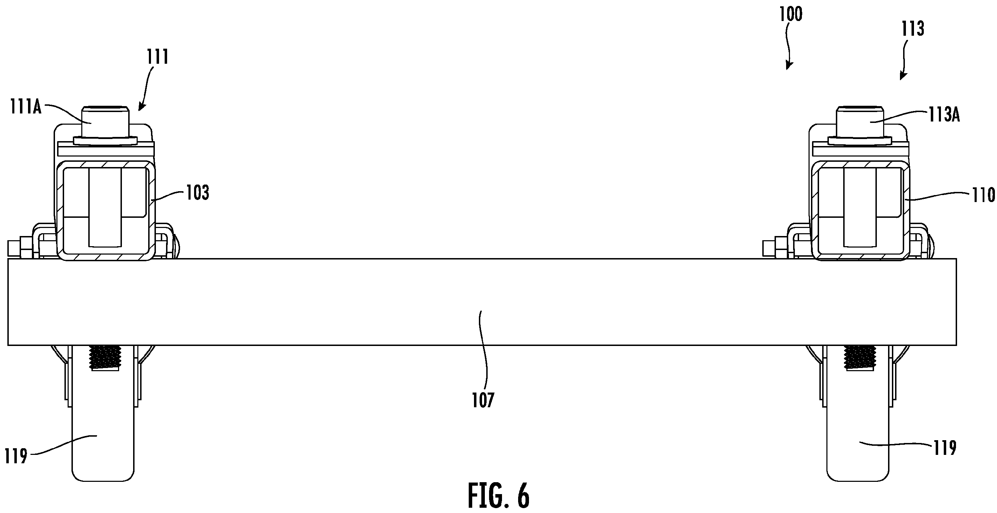

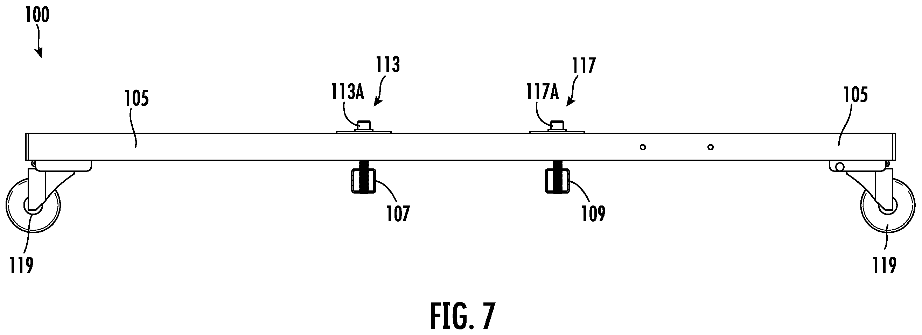

With brief reference to FIGS. 6 and 7, pivot points 111-117 each comprise a lifting bolt 111A-117A that engages with the corresponding first main bar 103, second main bar 105, first cross bar 107, or second cross bar 109 at the corresponding pivot point. The lifting bolts 111A-117A are actuated to move the first and second cross bars 107, 109 between a first position and a second position relative to the first main bar 103 or second main bar 105. In particular, when the lifting bolts 111A-117A are tightened, the first cross bar 107 and the second cross bar 109 is moved from a first position (FIG. 7) relative to the first main bar 103 or the second main bar 105 to a second position (FIG. 6) relative to the first main bar 103 or second main bar 105 wherein the second position is closer to the first main bar 103 or the second main bar 105 than the first position. Conversely, when the lifting bolts 111A-117A are loosened, the first cross bar 107 and the second cross bar 109 is moved from the second position (FIG. 6) relative to the first main bar 103 or the second main bar 105 to the first position (FIG. 7) relative to the first main bar 103 or second main bar 105 wherein the first position is further from the first main bar 103 or the second main bar 105 than the second position.

Referring back to FIGS. 4 and 5, telecommunications rack mover 100 further comprises a caster 119 on each of a first end 103A of first main bar 103, a second end 103B of first main bar 103, a first end 105A of second main bar 105, and a second end 105B of second main bar 105. The casters 119 enable movement of telecommunications rack mover 100 within data halls 26 and enable movement of telecommunications rack 32 when coupled to the telecommunications rack mover 100 as discussed herein.

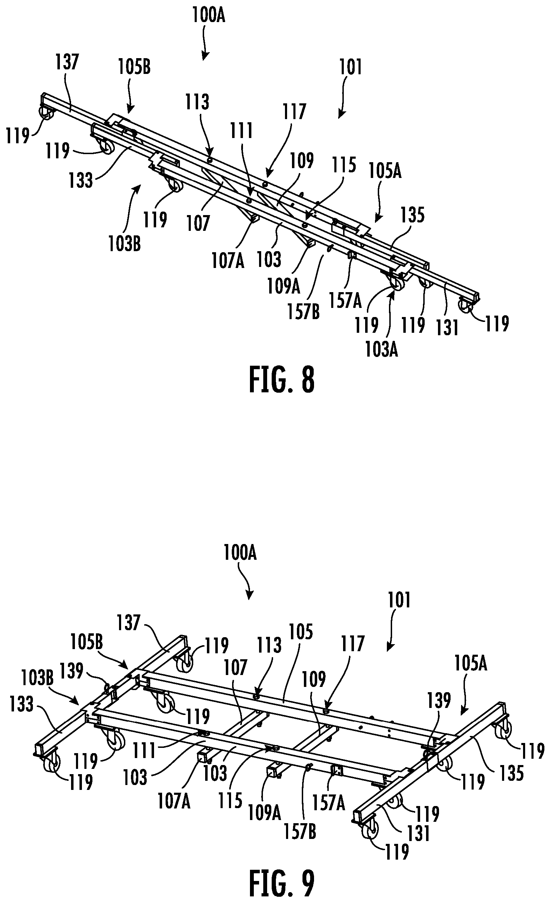

Referring now to FIGS. 8 and 9, an alternate embodiment of telecommunications rack mover 100A is shown. Various features pertaining to telecommunications rack mover 100A are now described with reference to the drawings, wherein like reference numerals are used to refer to like elements throughout. Telecommunications rack mover 100A is similar to telecommunications rack mover 100 described above, and the differences will be described below.

Telecommunications rack mover 100A further comprises a stabilizer bar that is coupled to the ends of the first and second lifting bars. In particular, first main bar 103 has a first end 103A and a second end 103B, and second main bar 105 has a first end 105A and a second end 105B. As shown, a first stabilizer bar 131 is pivotably coupled to the first end 103A of the first main bar 103, and a second stabilizer bar 133 is pivotably coupled to the second end 103B of the first main bar 103. Similarly, a third stabilizer bar 135 is pivotably coupled to the first end 105A of the second main bar 105, and a fourth stabilizer bar 137 is pivotably coupled to the second end 105B of the second main bar 105.

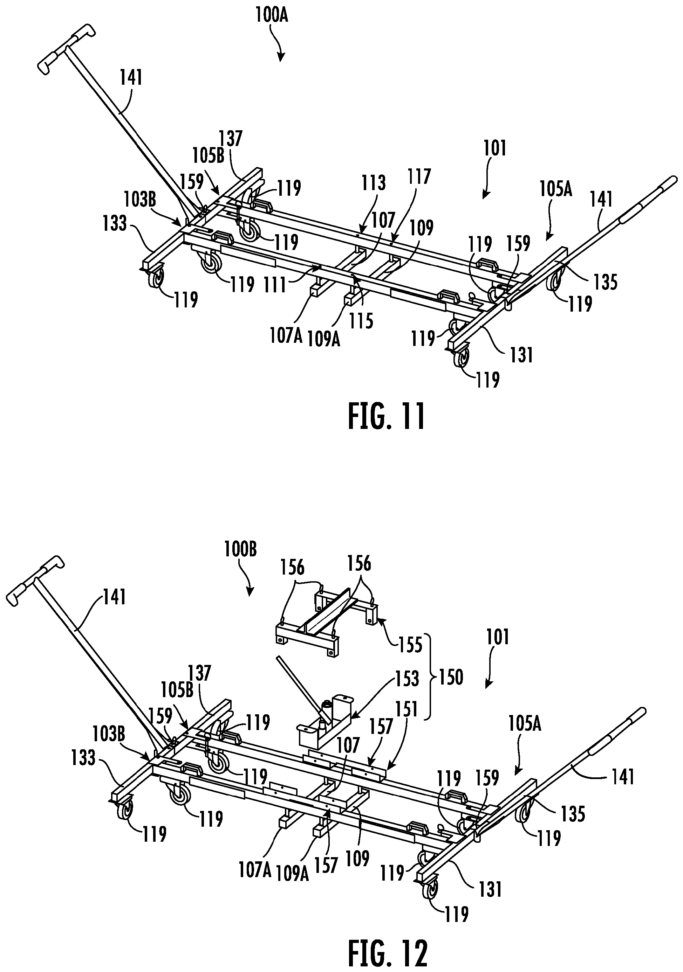

As shown, in the compressed configuration of FIG. 8, the stabilizer bars 131-137 are in a stored configuration where stabilizer bars 131-137 are substantially in line with the corresponding first main bar 103 and second main bar 105. Like telecommunications rack mover 100, when telecommunications rack mover 100A transitions from the compressed configuration of FIG. 8 to the expanded configuration of FIG. 9, the first cross bar 107 and the second cross bar 109 are spaced apart from each other, substantially parallel to each other, and are substantially perpendicular to the first main bar 103 and the second main bar 105. Further, in the expanded configuration, the stabilizer bars 131-137 are initially in the stored configuration. The stabilizer bars 131-137 can transition into an assembled configuration as shown in FIG. 9 where stabilizers 131-137 pivot inwardly with respect to the telecommunications rack mover 100A such that the first and third stabilizer bars 131, 135 are coupled to each other and the second and fourth stabilizer bars 133, 137 are coupled to each other. In some embodiments, the stabilizer bars 131-137 are coupled to each other such that the stabilizer bars 131-137 are substantially perpendicular to the first main bar 103 and the second main bar 105. In some embodiments, the stabilizer bars 131-137 are coupled to each other as previously mentioned and locked into place by a locking pin 139. In this way, the coupled first and third stabilizer bars 131, 135 and second and fourth stabilizer bars 133, 137 define a structure upon which handles 141 (FIG. 11) can attach onto and aid in moving and steering the telecommunication rack mover 100A.

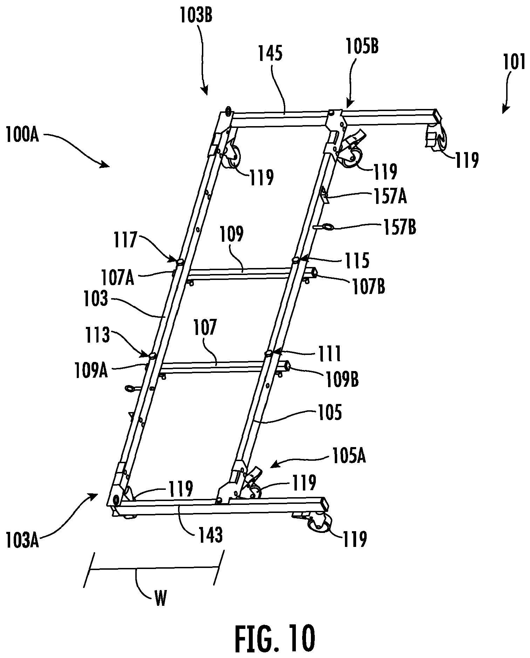

While pairs of stabilizer bars 131-137 are disclosed as shown in FIGS. 8 and 9, an alternative configuration is shown in FIG. 10. In particular, a first stabilizer bar 143 is pivotably coupled to the first end 103A of the first main bar 103, and a second stabilizer bar 145 is pivotably coupled to the second end 103B of first main bar 103. As shown, the first and second stabilizer bars 143, 145 are elongated such that the lengths of each of the first and second stabilizer bars 143, 145 are longer than the width W of the expandable frame 101 in the expanded configuration. In addition, when expandable frame 101 is in the expanded configuration and the stabilizer bars 143, 145 are transitioned to the assembled configuration, first and second stabilizer bars 143, 145 are pivoted about the ends 103A, 103B of the first main bar 103 such that the first and second stabilizer bars 143, 145 are moved to a position where the first and second stabilizer bars 143, 145 are coupled to the first end 105A and the second end 105B of the second main bar 105, respectively, and a portion of the first stabilizer bar 143 and a portion of the second stabilizer bar 145 extend beyond the second main bar 105.

Referring now to FIG. 12, another alternate telecommunications rack mover 100B is shown. As mentioned previously, various features pertaining to telecommunications rack mover 100B are now described with reference to the drawings, wherein like reference numerals are used to refer to like elements throughout. Telecommunications rack mover 100B is similar to telecommunications rack movers 100, 100A described above, and the differences will be described below.

As shown, telecommunications mover 100B further includes a jack assembly 150 that is applied onto the expandable frame 101. Jack assembly 150 comprises a carrier structure 151, a jack 153, and a lift structure 155, all of which are coupled to expandable frame 101. Carrier structure 151 provides a frame onto which the jack 153 and lift structure 155 are seated. Carrier structure 155 is coupled to lifting bolts 111A-117A and enables movement of lifting bolts 111A-117A as discussed in greater detail herein.

Jack 153 sits on the carrier structure 151 and couples to the lift structure 155. Jack 153 is actuated to raise or lower lifting bolts 111A-117A and raise or lower first cross bar 107 and second cross bar 109. In some embodiments, jack 153 is actuated by a mechanical lever as is known in the art. In an alternate embodiment, jack 153 is an electric jack that is actuated by a controller to raise or lower first cross bar 107 and second cross bar 109.

Lift structure 155 is applied onto the extendable frame 101 and is configured to couple to the lifting bolts 111A-117A such that when jack 153 is actuated, lifting bolts 111A-117A are raised or lowered which raises or lowers first cross bar 107 and second cross bar 109 between the first position and the second position as previously discussed. In particular, lift structure 155 includes pins 156 that couple lift structure 155 to carrier structure 151. When lift structure 155 is set on carrier structure 151, pins 156 are removed from lift structure 155 and inserted into holes 157 of carrier structure 151 to couple the lift structure 155 and the carrier structure 151 together..

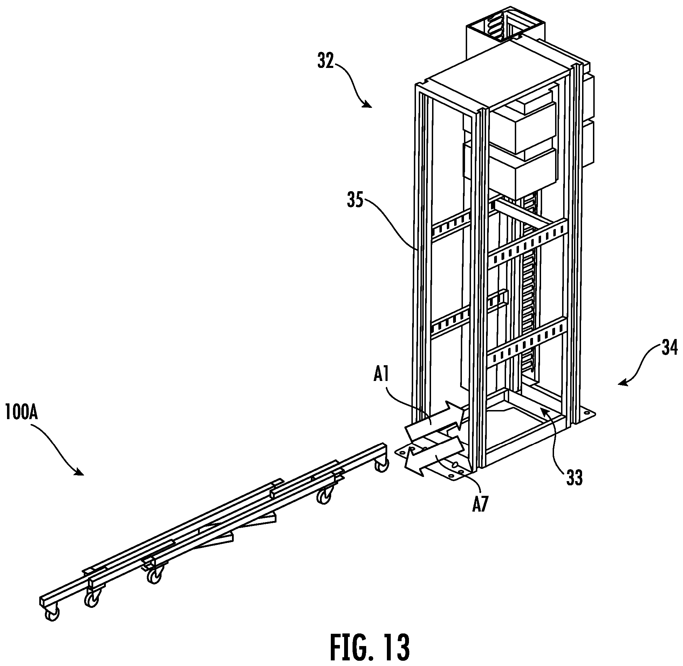

Referring now to FIGS. 13-18, a method of using the telecommunications rack mover 100A in the context of a telecommunications rack 32 is shown. While the method steps described below are in connection with the use of telecommunications rack mover 100A, the method can also be applied to the alternate embodiments of telecommunications rack movers 100, 100B described herein. Referring first to FIG. 13, a telecommunications rack mover 100A is in the compressed configuration and is moved along direction A1 into space 33 within a base 34 of the telecommunications rack 32.

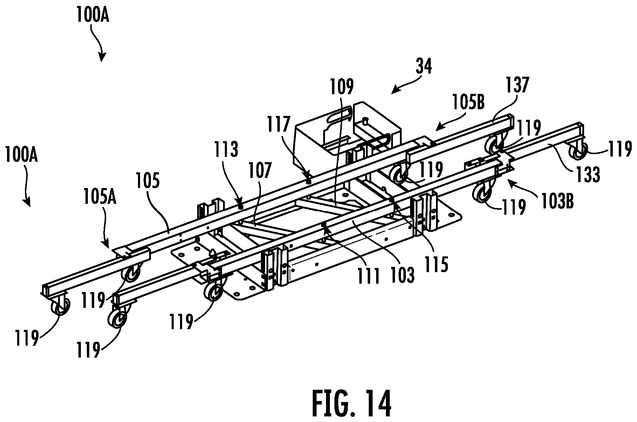

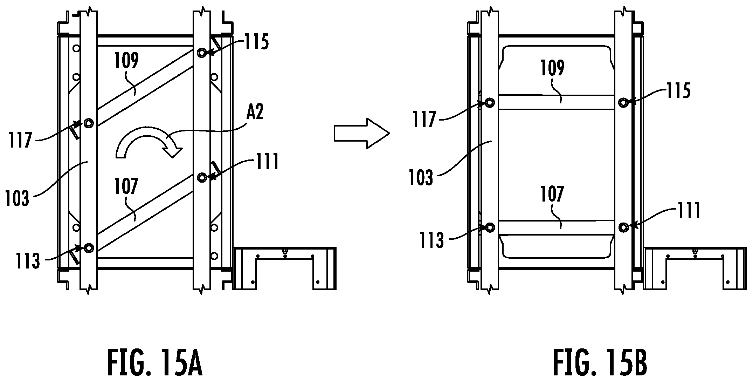

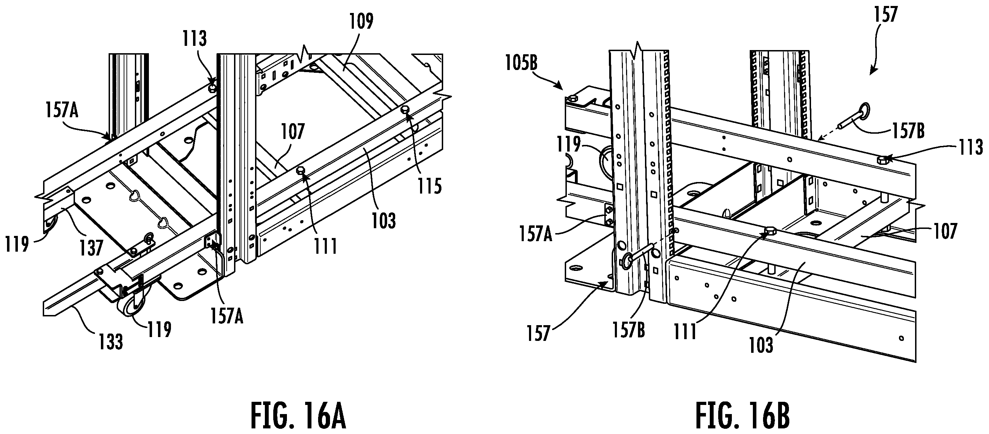

Then, as shown in FIGS. 14-15B, telecommunications rack mover 100A is transitioned from the compressed configuration to the expanded configuration by pivoting the first and second main bars 103, 105 and the cross bars 107, 109 of the expandable frame 101 about the corresponding pivot points 111-117 in a direction A2 (FIG. 15A). When the telecommunications rack mover 100A is moved into the expanded configuration, the portions of the cross bars 107, 109 that extend beyond the first main bar 103 and the second main bar 105 are positioned underneath a portion of the base 34 of telecommunications rack 32. In some embodiments, the portions of the first and second cross bars 107, 109 that extend beyond the first and second main bars 103, 105 are positioned underneath a flange of the base 34 of the telecommunications rack 32. In this configuration, locking structures 157 are applied such that the telecommunications rack 32 and the expandable frame 101 are coupled to each other as shown in FIGS. 16A-16B. This ensures that the expandable frame 101 does not move independently of the telecommunications rack 32. In some embodiments, the locking structures 157 include a stopping bracket 157A on the lifting bars 103, 105 and a locking pin 157B that is inserted into the expandable frame 101 to sandwich frame 35 (FIG. 3) of telecommunications rack 32 between the stopping bracket 157A and the locking pin 157B. However, it is within the scope of the present disclosure that alternate locking structures 157 may be used.

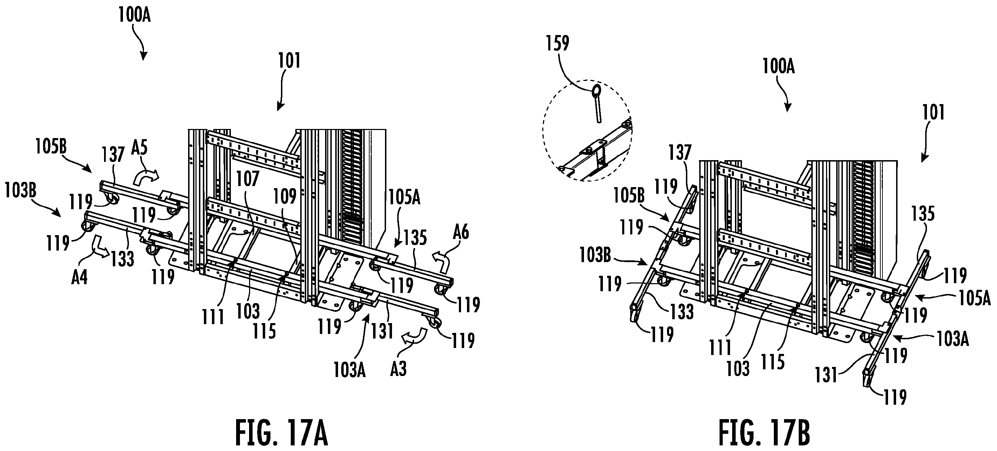

In embodiments where telecommunications rack mover 100A is used, stabilizer bars 131-137 are moved from the stored configuration to the assembled configuration as shown in FIGS. 17A-17B. In particular, stabilizer bars 131-137 are pivoted about respective first end 103A and second end 103B of first main bar 103 and respective first end 105A and second end 105B of second main bar 105 (pivoted in the corresponding directions A2-A6 as shown in FIG. 17A), and the stabilizer bars 131-137 are coupled to each other as shown. The stabilizer bars 131-137 can be held in place with locking pins 159 as shown in FIG. 17B.

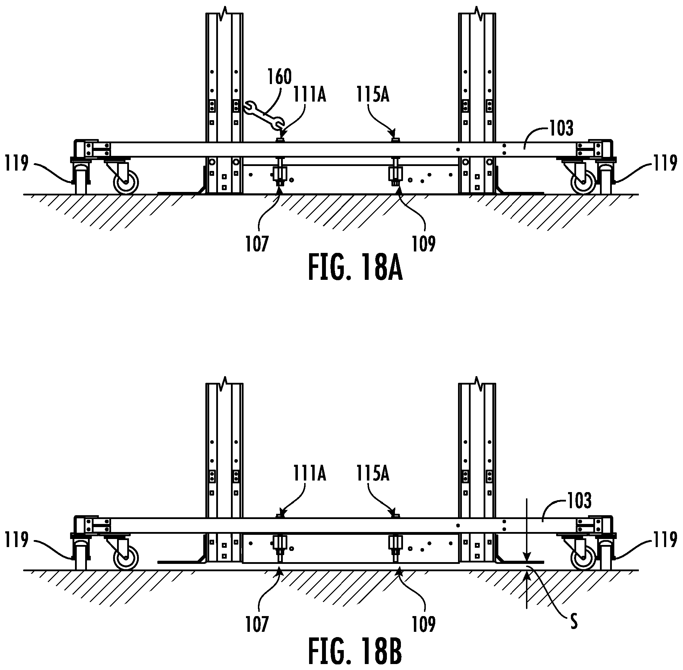

Then, with reference to FIGS. 18A and 18B, lifting bolts 111A-117A are actuated to lift telecommunications rack 32 from a resting position to a movable position. In particular, a tool 160 can be used to tighten lifting bolts 111A-117A to lift the first cross bar 107 and the second cross bar 109 such that the first cross bar 107 and the second cross bar 109 are closer to the first main bar 103 and the second main bar 105. In this configuration, the portions of the first cross bar 107 and the second cross bar 109 that extend beyond the first main bar 103 and the second main bar 105 are raised such that these portions engage with the base 34 of telecommunications rack 32 and lift the telecommunications rack 32 into the movable position from the resting position (i.e., off the surface upon which the telecommunications rack 32 rests). Stated another way, when telecommunications rack 32 is transitioned to the movable position from the resting position, there is space S between the telecommunications rack 32 and the surface upon which the telecommunications rack 32 rests. In some embodiments, tool 160 is a wrench or a power tool. Once telecommunications rack 32 is lifted, the telecommunications rack 32 can be moved by moving the telecommunications rack mover 100 on casters 119. In some embodiments, handles 141 are applied onto the stabilizer bar pairings (131, 135 and 133, 137) to aid a user in moving and steering the telecommunications rack mover 100A and telecommunications rack 32 within data hall 26 of data center 10.

When telecommunications rack 32 is moved to a proper location, telecommunications rack 32 is lowered into the resting position by using the tool 160 to loosen lifting bolts 111A-117A. Loosening lifting bolts 111A-117A lowers the first cross bar 107 and the second cross bar 109 to a first position that is further from the first main bar 103 and the second main bar 105 than in the previous second position when the lifting bolts 111A-117A are tightened. When the cross bars 107, 109 are lowered, the telecommunications rack 32 is lowered onto the surface upon which the telecommunications rack 32 rests, and the cross bars 107, 109 disengage from the telecommunications rack 32. To remove the telecommunications rack mover 100A, the locking pins 157, 159 are removed. Then, the stabilizer bars 131-137 are moved from the assembled configuration to the storage configuration, and the telecommunications rack mover 100A is transitioned to the compressed configuration shown in FIG. 13, and removed from the base 34 of telecommunications rack 32 along direction A7 (FIG. 13).

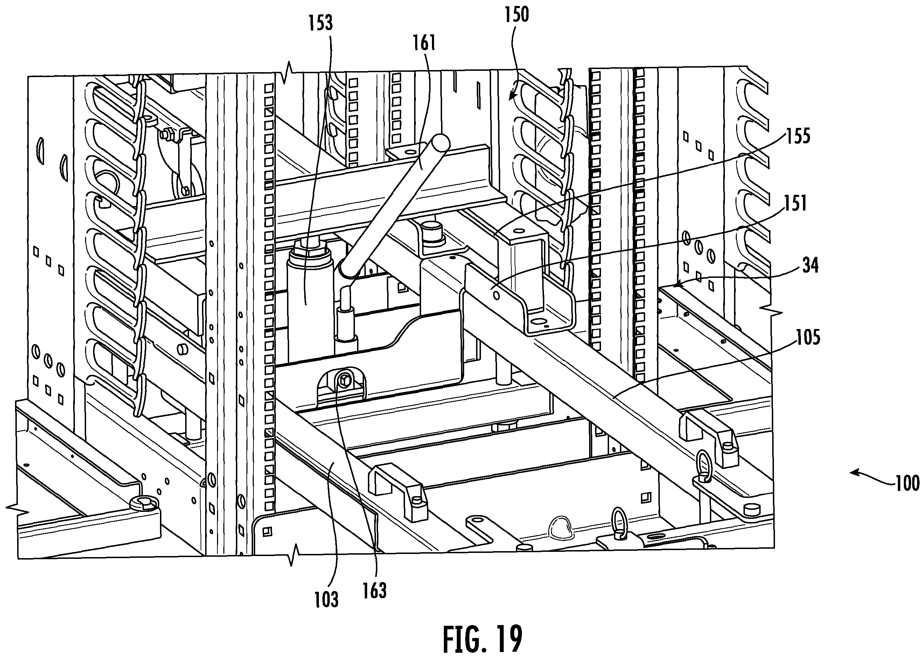

In embodiments with telecommunications rack mover 100B, as shown in FIG. 19, the jack assembly 150 is mounted onto the expandable frame 101 of the telecommunications rack mover 100. The jack 153 is actuated by a jack handle 161 to raise cross bars 107, 109 as discussed previously by raising lifting bolts 111A-117A. This, in turn, raises telecommunications rack 32 off the surface upon which telecommunications rack 32 rests and moves telecommunications rack 32 into the movable position (from the resting position). To lower telecommunications rack 32, a release valve 163 on the jack assembly 150 is actuated to lower lifting bolts 111A-117A and first and second cross bars 107, 109 and thereby, lower telecommunications rack 32.

It will be apparent to those skilled in the art that various modifications and variations can be made without departing from the spirit or scope of the illustrated embodiments. Since modifications, combinations, sub-combinations and variations of the disclosed embodiments that incorporate the spirit and substance of the illustrated embodiments may occur to persons skilled in the art, the description should be construed to include everything within the scope of the appended claims and their equivalents.

## Claims

1. An expandable frame for moving a telecommunications rack, comprising:
a first main bar and a second main bar, the second main bar being substantially parallel with the first main bar;
a first cross bar coupled to the first main bar and the second main bar; and
a second cross bar coupled to the first main bar and the second main bar, the second cross bar being substantially parallel with the first cross bar;
wherein the expandable frame is movable between a compressed configuration and an expanded configuration;
wherein in the compressed configuration, the first main bar and the second main bar are adjacent to each other; and
wherein in the expanded configuration, the first main bar is spaced apart from the second main bar.

2. The expandable frame of claim 1, wherein:
the first cross bar is coupled to the first main bar and the second main bar at a first pivot point and a second pivot point, respectively;
the second cross bar is coupled to the first main bar and the second main bar at a third pivot point and a fourth pivot point, respectively; and
when the expandable frame transitions between the compressed configuration and the expanded configuration, the first cross bar pivots about the first pivot point and the second point and the second cross bar pivots about the third pivot point and the fourth pivot point.

3. The expandable frame of claim 2, wherein the first pivot point, the second pivot point, the third pivot point, and the fourth pivot point each comprise a lifting bolt that engages with the corresponding first main bar, the second main bar, the first cross bar, and the second cross bar.

4. The expandable frame of claim 3, wherein when the lifting bolt is tightened, the first cross bar or the second cross bar is moved from a first position relative to the first main bar or the second main bar to a second position relative to the first main bar or the second main bar, wherein the second position is closer to the first main bar or the second main bar than the first position.

5. The expandable frame of claim 4, wherein the first cross bar and the second cross bar are each configured to engage with a telecommunications rack when the expandable frame is in the expanded configuration and when the first cross bar and the second cross bar are in the second position.

6. The expandable frame of claim 5, wherein the expandable frame is configured to lift the telecommunications rack from a resting position to a movable position when the first cross bar and the second cross bar engage with the telecommunications rack in the second position.

7. The expandable frame of claim 6, wherein when the lifting bolt is loosened the first cross bar or the second cross bar is moved to the first position, and the telecommunications rack is moved to the resting position.

8. The expandable frame of any of claims 1-7, wherein the first main bar and the second main bar each include at least one caster configure to enable movement of the expandable frame.

9. The expandable frame of any of claims 1-8, further comprising:
the first main bar having a first end and a second end;
the second main bar having a first end and a second end;
a first stabilizer bar pivotably coupled to the first end of the first main bar;
a second stabilizer bar pivotably coupled to the second end of the first main bar;
a third stabilizer bar pivotably coupled to the first end of the second main bar;
a fourth stabilizer bar pivotably coupled to the second end of the second main bar;
wherein in the expanded configuration:
the first stabilizer bar and the second stabilizer bar are pivotable between a stored configuration in which the first stabilizer bar and the second stabilizer bar are substantially parallel to the first cross bar and the second cross bar and an assembled configuration in which the first stabilizer bar and the second stabilizer bar are substantially perpendicular to the first main bar and the second main bar; and
the third stabilizer bar and the fourth stabilizer bar are pivotable between a stored configuration in which the third stabilizer and the fourth stabilizer bar are substantially parallel to the first cross bar and the second cross bar and an assembled configuration in which the third stabilizer bar and the fourth stabilizer bar are substantially perpendicular to the first main bar and the second main bar.

10. The expandable frame of claim 9, wherein in the expanded configuration:
the first stabilizer bar and the third stabilizer bar are coupled to each other; and
the second stabilizer bar and the fourth stabilizer bar are coupled to each other.

11. The expandable frame of claim 10, further comprising at least one handle coupled to at least one of the first stabilizer bar and the third stabilizer bar in the assembled configuration or at least one of the second stabilizer bar and the fourth stabilizer bar in the assembled configuration.

12. The expandable frame of any of claims 9-11, further comprising:
a jack assembly coupled to the expandable frame in the expanded configuration, wherein the jack assembly comprises a jack that is coupled to the expandable frame such that the jack raises or lower the lifting bolt to transition the lifting bolt between a first position relative to the first main bar or the second main bar and a second position relative to the first main bar or the second main bar;
wherein the second position of the lifting bolt is closer to the first main bar or the second main bar than the first position of the lifting bolt.

13. A method of moving a telecommunications rack using the expandable frame of any of claims 1-12, the method comprising:
moving the expandable frame into a base of the telecommunications rack when the expandable frame is in a compressed configuration in which the first main bar and the second main bar are adjacent to each other;
expanding the expandable frame from the compressed configuration to an expanded configuration in which the first main bar is spaced apart from the second main bar;
engaging the first cross bar and the second cross bar with the telecommunications rack;
lifting the telecommunications rack using the expandable frame; and
moving the telecommunications rack using the expandable frame.
